# EUROPEAN PATENT APPLICATION

(11) **EP 2 388 600 A1**
(43) Date of publication of application: **23.11.2011**
(21) Application number: 11166233.4
(22) Date of filing: 16.05.2011
(51) Int. Cl.: G01R 29/18, H02J 13/00

(54) **Phase Identification system**

(30) Priority: 18.05.2010 US 782530
(71) Applicant: General Electric Company, Schenectady, NY 12345 (US)
(72) Inventor: Kolwalkar, Amol Rajaram, 560066 Bangalore (IN); Tomlinson, Harold Woodruff, Niskayuna, NY 12309 (US); Sen, Bhaskar, 560066 Bangalore (IN); Hershey, John Erik, Niskayuna, NY 12309 (US); Koste, Glen Peter, Niskayuna, NY 12309 (US)
(74) Representative: Gray, Thomas

(57) **Abstract**

Methods and systems are described for determining a phase of transmitted voltage. In one embodiment, a power distribution system (12) may operate to transmit voltage and an injected signal (58). The system may also include a power meter (22) that may receive the voltage and injected signal (58). The power meter (22) may determine a phase of the received voltage based on the received voltage and the injection signal (58).

## Description

### BACKGROUND OF THE INVENTION

This invention relates to the measurement and determination of the phase of electricity provided over a power distribution grid.

Modem power distribution systems may deliver three phase voltage to users. That is, a power line may, for example, include a plurality of conductors each designated as a specific phase of voltage. Moreover, the power distribution system may be set up to operate such that the loads of the power line are balanced (e.g., the amount of power drawn from each phase output of, for example, a three-phase transformer, are equal). However, over time, users may be added and removed from the network, which may result in an imbalance in the phase currents and voltage flow. That is, too many users may be connected to one phase of voltage while too few are connected to a second and/or third phase. This may result in a non-optimal utilization of the existing infrastructure. One manner of overcoming this load imbalance may be to institute a rebalancing of the loads, for example, by moving customers from a more highly used phase of voltage to a lesser used phase of voltage.

However, there exist challenges in moving customers from one phase of voltage to another. For instance, as customers are added to and subtracted from a power distribution network, the phase of voltage that a given customer is connected to may be difficult to ascertain without costly physical tracking (typically by a worker in the field) of a given power line to the network. That is, while a load imbalance may be detected remotely, the phase to which the individual users are connected to may not be readily apparent without physically tracking the power lines from a substation to the respective user locations. Accordingly, it would be advantageous to ascertain the phase of voltage to which a user is connected to without sending a person to one or more user sites to physically determine the voltage phase being received at the various sites.

### BRIEF DESCRIPTION OF THE INVENTION

In a first embodiment, a system includes a power distribution station adapted to generate an injected signal at a specified time and to transmit voltage and the injected signal, and a phase detection device adapted to receive the voltage and the injected signal and to determine a phase of the received voltage based on the relationship between the received voltage and the injected signal.

In a second embodiment, a system includes a phase detection device adapted to receive a voltage in one of three phases, receive an injected signal with the voltage, and determine a phase of the voltage based on the received voltage and the injected signal.

In a third embodiment, a method including receiving at a power meter a voltage in one of three phases, receiving at the power meter an injected signal, and determining at the power meter a phase of the voltage based on the received voltage and the injected signal.

### BRIEF DESCRIPTION OF THE DRAWINGS

These and other features, aspects, and advantages of the present invention will become better understood when the following detailed description is read with reference to the accompanying drawings in which like characters represent like parts throughout the drawings, wherein:
FIG. 1 is a block diagram of a power grid, in accordance with an embodiment of the present invention;
FIG. 2 is a block diagram of a phase detection device of the power grid of FIG. 1, in accordance with an embodiment of the present invention;
FIG. 3 is a block diagram of the power distribution station of the power grid of FIG. 1, in accordance with an embodiment of the present invention;
FIG. 4 is a graphical representation of an injection signal in connection with voltage provided by the power distribution station of FIG. 3, in accordance with an embodiment of the present invention; and
FIG. 5 is a graphical representation of correlation peaks of an injected signal and their relation to three voltage phases provided by the power distribution station of FIG. 3, in accordance with an embodiment of the present invention.

### DETAILED DESCRIPTION OF THE INVENTION

Certain embodiments commensurate in scope with the originally claimed invention are summarized below. These embodiments are not intended to limit the scope of the claimed invention, but rather these embodiments are intended only to provide a brief summary of possible forms of the invention. Indeed, the invention may encompass a variety of forms that may be similar to or different from the embodiments set forth below.

A method and system is described for identifying which phase of voltage a customer is connected to in a power grid. One or more power lines in the power grid may be used to transmit an injected signal along with the voltage transmitted along the lines. The injected signal may, for example, be injected at a power distribution substation of the power grid. This injected signal may travel over the one or more power lines of the power grid and may be detected at a phase detection device, for example, located at a user's residence or workplace or at, for example, a single-phase distribution transformer. Additionally, or alternatively, the injected signal may be detected by, for example, a portable hand-held metering device such that individual phases of the transmitted voltage may be identified based on the injected signal received at the meter. This may be accomplished via measuring and processing of the signal. In another embodiment, the frequency of the injected signal may be utilized to identify the location of the generation of the injected signal, e.g., the substation from which a given meter receives its voltage.

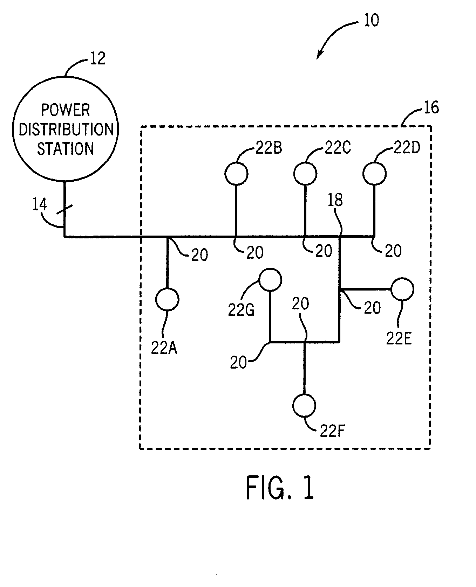

FIG. 1 illustrates a power grid 10 that may operate to provide voltage from a power distribution station 12. The power distribution station 12 may, for example, include a power plant including one or more power generators that may generate voltage for transmission on the power grid 10. Additionally, or alternatively, the power distribution station may include one or more power substations that may include one or more transformers that operate to transform voltage from one voltage to another (e.g., step-down received voltages from, for example, 100,000 volts to less than 10,000 volts) and/or one or more distribution busses for stepping-down the voltage from approximately 10,000 volts to approximately 7,200 volts and further routing the voltage. The power distribution station 12 may also be connected to a power distribution network 16 via, for example, one or more power lines 14.

In one embodiment, the power lines 14 may include a plurality of transmission paths for transmission of voltage from the power distribution station 12 to the power distribution network 16. For example, the power lines 14 may transmit voltage in three phases, e.g. phases A-C. Additionally, the power lines 14 may include a ground line in addition to the paths for transmission of the three phases of voltage, phases A-C. The three phase voltage, as well as the ground signal, may additionally be transmitted to the power distribution network 16.

The power distribution network 16 may distribute the three phase voltage to a plurality of users. The distribution network 16 may include, for example, one or more taps 18. The one or more taps may operate to split off one or more of the power lines 14 to, for example, a side street on which one or more users reside. The tap 18 may thus operate to split one or more of the voltage phases A-C to the users on this side street. The power distribution network 16 may also include user lines 20. The user lines 20 may operate as direct connections to the power lines 14. That is, each user line 20 may include, for example, a transformer drum for stepping down the voltage from approximately 7200 volts to approximately 240 volts. Additionally, it should be noted that each of the user lines 20 may be connected to a single phase of voltage. That is, each user line 20 may be connected to phase A, phase B, or phase C voltage. The 240 volt phase A, phase B, or phase C voltage may be transmitted to a user with meters 22A-22G connected in the circuit.

Each of the meters 22A-22G (e.g., phase detection devices) may operate to monitor the amount of energy being transmitted to and consumed by a particular user. In one embodiment, one or more of the meters 22A-22G may be a portion of an advanced metering infrastructure (AMI) such that the meters 22A-22G may measure and record usage data in specified amounts over predetermined time periods (such as by the minute or by the hour), as well as transmit the measured and recorded information to the power distribution station 12. In another embodiment, the meters 22A-22G may allow for transmission of additional information, such as power outages, voltage phase information, or other infrastructure information, to be sent to the power distribution station 12 for assessment.

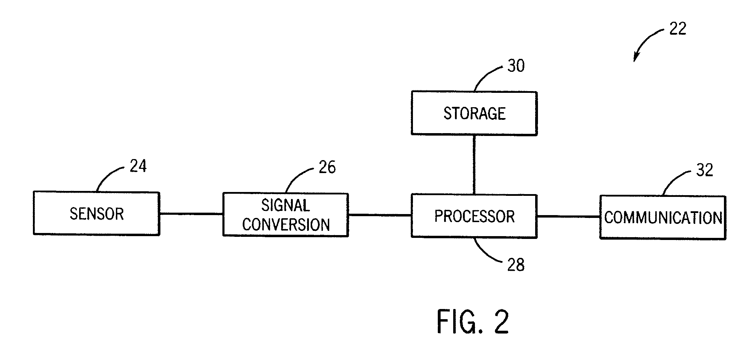

FIG. 2 illustrates a block diagram of one of the meters 22, which may be representative of any of the meters 22A-22G. As illustrated, the meter 22 may include a sensor 24, signal conversion circuitry 26, one or more processors 28, storage 30, and communication circuitry 32. In conjunction, the sensor 24, the signal conversion circuitry 26, one or more processors 28, the storage 30, and the communication circuitry 32 may allow the meter 22 to determine and transmit a signal indicative of the phase of voltage being received at the meter 22. In this manner, the meter 22 may operate as a phase detection device. Additionally or alternatively, the determination and transmission of a signal indicative of the phase of voltage being received at the meter 22 may be accomplished by a portable hand-held metering device. In one embodiment, the sensor 24 may include electrical components for receiving and measuring the current and voltage from the user line 20. As noted above, this voltage may be in one of three phases, phase A, phase B, or phase C, each 120 degrees out of phase with one another. The sensor 24 may transmit the detected voltage and/or current as a signal to the signal conversion circuitry 26. Additionally, the sensor 24 may detect an injected signal in addition to the voltage received at the meter 22. As will be discussed in greater detail below, the injected signal may allow for a determination of the received phase of voltage at the meter 22.

Also illustrated in FIG. 2 is signal conversion circuitry 26. The signal conversion circuitry 26 may include, for example, voltage conversion circuitry 26 to convert the voltage of the signal received from the sensor 24 from 240 volts to approximately 5 volts or less. Additionally, the voltage conversion circuitry may, for example, include at least one analog to digital converter for transforming signals received from the sensor 24 (such as voltage signals or injected signals) from analog form into digital signals for processing by one or more processors 28.

The one or more processors 28 may provide the processing capability for the meter 22. The one or more processors 28 may include one or more microprocessors, such as one or more "general-purpose" microprocessors, one or more special-purpose microprocessors and/or ASICS, or some combination of such processing components. Additionally, programs or instructions executed by the one or more processors 28 may be stored in any suitable manufacture that includes one or more tangible, computer-readable media at least collectively storing the executed instructions or routines, such as, but not limited to, the storage device described below. As such, the meter 22 may include programs encoded on a computer program product (such as storage 30), which may include instructions that may be executed by the one or more processors 28 to enable the meter 22 to provide various functionalities, including determining the phase of voltage received at the meter 22 based on, for example, a received injected signal.

The instructions and/or data to be processed by the one or more processors 28 may be stored in a computer-readable medium, such as storage 30. The storage 30 may include a volatile memory, such as random access memory (RAM), and/or a nonvolatile memory, such as read-only memory (ROM). In one embodiment, the storage 30 may store firmware for the meter 22 (such as various programs, applications, or routines that may be executed on the meter 22). In addition, the storage 30 may be used for buffering or caching during operation of the meter 22. The storage 30 may include, for example, flash memory, a hard drive, or any other optical, magnetic, and/or solid-state storage media. The storage 30 may also be used to store information for eventual transmission via communication circuitry 32.

Communication circuitry 32 may be utilized to transmit information from the meter 22 to, for example, the power distribution station 12. The information may, for example, include one or more signals indicating the phase of voltage being received at the meter 22, the voltage usage at the meter 22, and/or other information relating to the operation of the meter 22. Accordingly, the communication circuitry 32 may include, for example, a transceiver for transmitting and receiving information with the power distribution station 12 and/or other meters (e.g., 22A-22G). The communication circuitry 32 may, instead, include a transmitter, which may allow for transmission of information to, for example, the power distribution station 12 and/or other meters, but will not receive information. The communication circuitry 32 may further include wireless transmission and/or transceiver elements for wireless transmission and/or reception of information. Additionally and/or alternatively, the communication circuitry 32 may be physically coupled to, for example, the power distribution station 12 for monitoring. Regardless of the transmission medium, through the use of communication circuitry 32, the meter 22 may be able to transmit collected information including the phase of voltage being received at the meter 22.

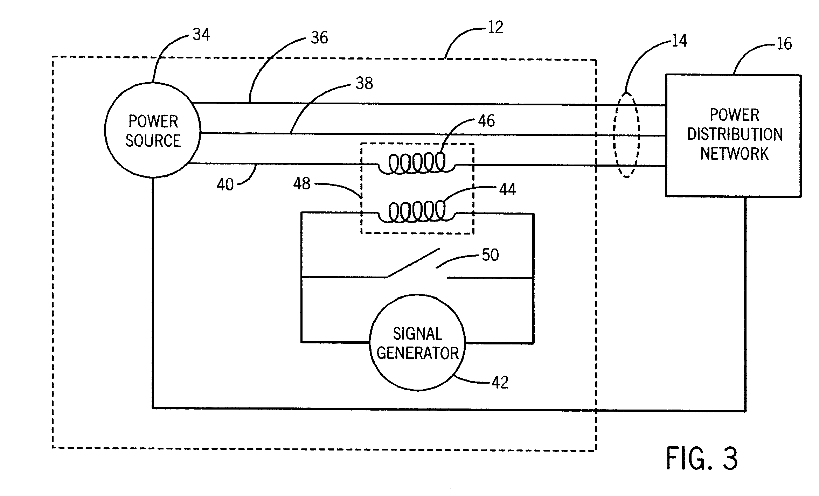

FIG. 3 is a block diagram of the power distribution station 12 that may be utilized in conjunction with the meters 22 to determine the phase of voltage being supplied to a given user. The power distribution station 12 may include a power source 34. This power source may include, for example, a power generator or one or more transistors, as discussed above. The power source 34 may operate to transmit three phase voltage across power lines 14, such that phase A voltage may be transmitted across line 36, phase B voltage may be transmitted across line 38, and phase C voltage may be transmitted across line 40. In one embodiment, the power distribution station 12 may operate to inject an additional signal, for example, a high frequency signal, onto one or more of the lines 36, 38, and 40. This high frequency signal may be an oscillating signal at approximately 600 Hz, 1 kHz, 2 kHz, 3 kHz, 4 kHz, 5 kHz or more. In one embodiment, the signal for injection may be generated by a signal generator 42. This generated signal may be coupled on line 40 through a transformer 48 that includes inductors 44 and 46. The transformer 48 may operate to introduce the injected signal onto line 40 for transmission to the power distribution network 16 when a bypass switch 50 is open. Alternatively, when the bypass switch 50 is closed, no signal will be injected onto line 40. In this manner, the timing and duration of the injection of the injected signal may be controlled.

As will be discussed in greater detail below, the injected signal may be utilized by each of the meters 22 to determine the phase of voltage received by each meter 22. Additionally, as multiple substations in the power distribution station 12 may be present, in one embodiment, each substation may inject a signal at a different specified frequency. In this manner, when the injected signal is received at a meter 22, the origin of the received voltage may be established, based on the frequency of the received injected signal. For example, a first substation may inject one or more signals at a frequency of approximately 1 kHz. Additionally, a second substation may inject a second one or more injection signals at a frequency that differs from the first substation, for example, 2 kHz. As a meter 22 receives voltage, along with one of the injection signals, the meter 22 may be able to determine which substation the voltage was transmitted from, based on the frequency of the received injection signal (e.g. either 1 kHz or 2 kHz). This information may also be transmittable to the power distribution station 12.

The signal injected onto line 40 may experience interphase coupling with lines 36 and 38. That is, though initially injected on a single line (e.g., line 40), the injected signal may become present on each of other lines (e.g., lines 36 and 38) through interphase coupling. However, by proper timing of the injection of the signal, each of the meters 22 may be able to determine which phase of voltage it is receiving despite the injected signal being present on each of lines 36, 38, and 40.

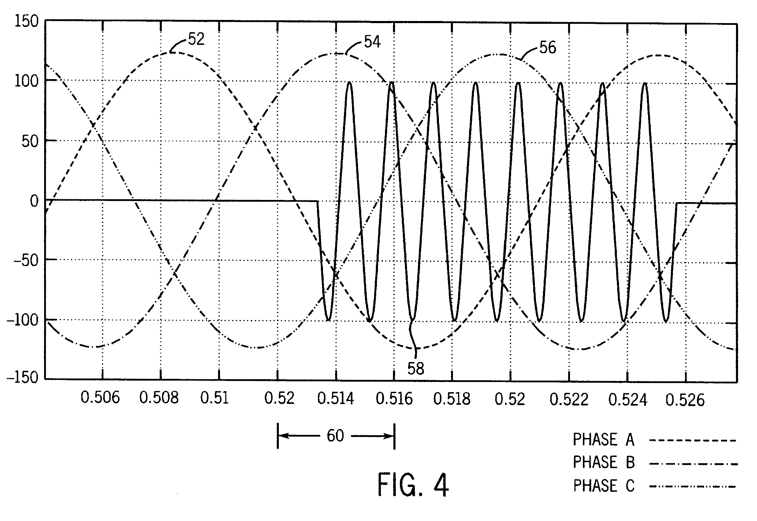

FIG. 4 is a graphical representation of an injection signal in connection with voltage provided by the power distribution station 12. Each of the meters 22 may receive both the injected signal 58 and a voltage, in one of phase A voltage 52, phase B voltage 54, or phase C voltage 56, as discussed above. In one embodiment, the injected signal 58 may be injected at the peak of one of the voltage phases 52, 54, or 56. For example, the injected signal 58 may be injected as phase A voltage 52 is at a peak, e.g. during time period 60. Additionally, during time period 60, phase B voltage 54 is on a positive upswing (i.e., the voltage is increasing in a positive value), while phase C voltage 56 is on a negative downswing (i.e., the voltage is increasing in negative value). Thus, each of the phases of voltage 52, 54, and 56 are in a different state as the injected signal 58 is introduced into, for example, power line 40. That is, the time based injection of the injected signal 58 may be utilized to determine the phase of voltage 52, 54, and 56.

While the voltage flows through the distribution network 16, the injected signal 58 is transmitted along with the voltage. Moreover, due to interphase coupling, the injected signal 58 may be carried along with each phase of voltage 52, 54, and 56. When a given meter, e.g. 22, receives the injected signal 58, along with the transmitted voltage, the meter, e.g. 22, may operate to determine the phase of the voltage. That is, each meter 22 may monitor the voltage characteristics of the voltage received from the time that the injected signal 56 is detected at the meter 22. If the value of the voltage is at a peak when the injected signal 56 is received, then the phase detection device 22 may determine that the phase of voltage being received is phase A voltage 52. If, however, the value of the voltage is increasing with a positive direction of a slope (i.e., if the voltage is rising as the injected signal 56 is received), then the phase detection device 22 may determine that the phase of voltage being received is phase B voltage 54. Finally, if the value of the voltage is decreasing with a negative direction of a slope (i.e., if the voltage is decreasing as the injected signal 56 is received), then the phase detection device 22 may determine that the phase of voltage being received is phase C voltage 56. That is, based on the waveform characteristics of the measured voltage at the time the injected signal 58 is detected (e.g., the relation between the injected signal 58 and an oscillating wave such as a sine wave) and/or based on the measured voltage received subsequent to the receipt of the injected signal, the meters 22 may determine the phase of voltage being received. This information may then be logged in the storage 30, or may be transmitted via communication circuitry 32.

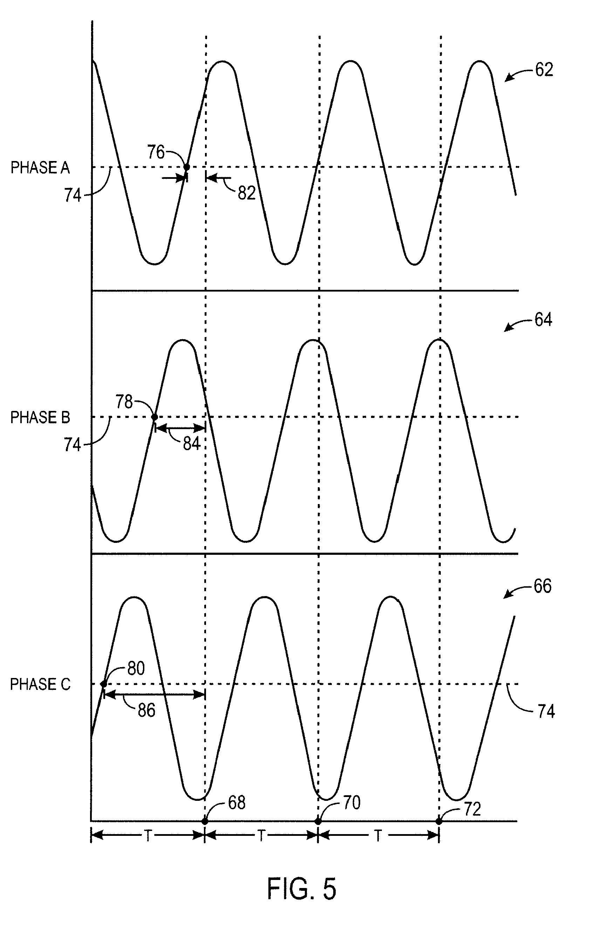

FIG. 5 is a graphical representation of a second technique for detecting phase of voltage received in each of a group of phase meters 22A-22G. This technique may include simultaneously transmitting a high-frequency voltage waveform, i.e., an injected signal, from the power distribution substation 12 onto each of lines 36, 38, and 40. In one embodiment, the injected signal may be a high-frequency reference voltage, for example, a reference voltage modulated about a carrier frequency of approximately 400 Hz, 500 Hz, 600 Hz, 1 kHz, 2 kHz, or more. Furthermore, the modulation may be selected such that the injected signal has a correlation function with a sharp maxima at a given period. For example, this period may be every 16.7ms (i.e., at a 60 Hz cycle), or at an integer multiple of 16.7 ms.

As seen in FIG. 5, the correlation peaks of the injected signal, occurring at times 68, 70, and 72, is represented in graph 62 with respect to phase A voltage 52 (i.e., the injected signal having been injected on power line 36), correlation peak of the injected signal is represented in graph 64 with respect to phase B voltage 54 (i.e., the injected signal having been injected on power line 38), and the correlation peak of the injected signal is represented in graph 66 with respect to phase C voltage 56 (i.e., the injected signal having been injected on power line 40). As noted above, the injected signal may have been selected such that the injected signal has a correlation function with a sharp maxima at a given period, for example, every period T (e.g., T may be approximately 16.7 ms).

As illustrated in graphs 62, 64, and 66, the voltage waveform of the three voltage phases may be phase shifted with respect to each of the correlation peaks 68, 70, and 72 since the injected signal is transmitted simultaneously on phase A voltage 52, phase B voltage 54, or phase C voltage 56. To determine what phase the meter is on, the voltage waveform at the meter is digitized by signal conversion 26 when the injected signal is expected to be present in the voltage waveform. This may be on a schedule that is known by both the meter and the power distribution station 12. The digitized waveform may then be filtered to remove the fundamental frequency of the voltage waveform, typically 60Hz in the United States. The filter could be, for example, a digital high-pass filter or band-reject filter. The filtered waveform may then be correlated with a replica of the injected signal that may be stored in each meter 22A-22G on the power distribution network 16. The correlation could be performed, for example, by a sliding window correlator, whereby the replica of the injected signal is advanced in time for each correlation step over the filtered waveform. The result of the correlation may be searched for local maxima, which may indicate a timing match between the replica of the injected waveform and the waveform received by sensor 24.

When a correlation peak, e.g., correlation peak 68, is found, a zero crossing for the phase voltage signal may be determined. The zero crossing may be measured as the phase voltage moves across a midpoint 70 from negative to positive value. For example, a zero crossing is illustrated in graph 62 at point 76, a zero crossing is illustrated in graph 64 at point 78, and a zero crossing is illustrated in graph 66 at point 80. The meter, e.g., meter 22A, may then determine the time difference, e.g., time difference 82, time difference 84, or time difference 86, between the zero crossing, e.g., at point 76, and the correlation peak, e.g., correlation peak 68. The time difference (e.g., time difference 82, time difference 84, or time difference 86) between the zero crossing (points 76, 78, or 80) and the correlation peak (e.g., correlation peak 68) may determine which phase the meter, e.g., 22A, is connected to. That is, the calculated time differences 82, 84, and 86 may correspond to phase A voltage 52, phase B voltage 54, or phase C voltage 56, respectively for a given correlation peak, e.g., correlation peak 68. This result, the phase of the voltage, may then be transmitted back to, for example, the power distribution station 12.

It is envisioned that phase identification of received voltage utilizing the technique graphically illustrated in graphs 62, 64, and 66 may be performed on a schedule. For example, the process may be undertaken by various meters 22A-22G on a daily, weekly, monthly, or yearly basis. Additionally or alternatively, the process may be implemented by a user at the power distribution station 12 or by a user in the field (e.g., on site at the location of one of the meters 22A-22G). Furthermore, it is envisioned that the replica of the injected signal previously discussed as being stored in each meter 22A-22G on the power distribution network 16, may also be generated at each of the meters 22A-22G. For example, each of the meters 22A-22G may generate the replica via utilization of, for example, a low multi-tone crest-factor sequence supplied by sequences forming Golay complementary pairs, a segment of the Thue-Morse sequence (which may be defmed as the mod-2 sum of the contents of a normal binary counter), or a voltage waveform proportional to a non-binary sequence related to a segment of the Thue-Morse sequence. Upon generating the replica of the injected signal, a correlation peak, e.g., 68, may be found and a zero crossing (e.g., points 76, 78, or 80) for the injected signal may be determined so that the time difference 82, time difference 84, or time difference 86 may be calculated to determined which phase the meter, e.g., 22A, is connected to.

This written description uses examples to disclose the invention, including the best mode, and also to enable any person skilled in the art to practice the invention, including making and using any devices or systems and performing any incorporated methods. The patentable scope of the invention is defmed by the claims, and may include other examples that occur to those skilled in the art. Such other examples are intended to be within the scope of the claims if they have structural elements that do not differ from the literal language of the claims, or if they include equivalent structural elements with insubstantial differences from the literal language of the claims.

For completeness, various aspects of the invention are now set out in the following numbered clauses:
1. A system, comprising:
   a power distribution station adapted to generate an injected signal at a specified time and to transmit voltage and the injected signal; and
   a phase detection device adapted to receive the voltage and the injected signal and to determine a phase of the received voltage based on the relationship between the received voltage and the injected signal.
2. The system of clause 1, wherein the phase detection device comprises a power meter.
3. The system of clause 1, wherein the phase detection device comprises a hand-held metering device.
4. The system of clause 1, wherein the phase detection device determines the phase of the received voltage by determining a time relationship between the injected signal and an oscillating wave of the received voltage.
5. The system of clause 1, wherein the phase detection device determines the phase of the received voltage by determining a direction of a slope of the received voltage during a measurement time period subsequent to receiving the injected signal.
6. The system of clause 1, wherein the power distribution station comprises a signal generator adapted to generate the injected signal.
7. The system of clause 6, comprising a power line, wherein the power distribution station comprises a transformer adapted to transfer the injected signal onto the power line for transmission to the phase detection device.
8. The system of clause 1, wherein the phase detection device comprises a transmitter adapted to transmit a signal indicative of the phase of the received voltage to the power distribution station.
9. The system of clause 8, wherein the transmitter comprises a wireless transmitter adapted to wirelessly transmit a signal indicative of the phase of the received voltage to the power distribution station.
10. A system, comprising:
   a phase detection device adapted to:
      receive a voltage in one of three phases;
      receive an injected signal with the voltage; and
      determine a phase of the voltage based on the received voltage and the injected signal.
11. The system of clause 10, wherein the phase detection device comprises a transmitter adapted to transmit an indication of the phase of the voltage transmission.
12. The system of clause 10, wherein the phase detection device comprises a transceiver adapted to transmit an indication of the phase of the voltage.
13. The system of clause 10, wherein the phase detection device is adapted to determine the phase of the voltage based on the difference between a calculated zero crossing of the injected signal with a correlation peak.
14. The system of clause 13, wherein the correlation peak is determined based on a comparison of the injected signal with a stored replica of the injected signal.
15. The system of clause 13, wherein the correlation peak is determined based on a comparison of the injected signal with a calculated replica of the injected signal.
16. The system of clause 10, wherein the injected signal comprises a sequence forming Golay complementary pairs, a segment of a Thue-Morse sequence, or a non-binary sequence related to the segment of the Thue-Morse sequence.
17. A method, comprising:
   receiving at a power meter a voltage in one of three phases;
   receiving at the power meter an injected signal; and
   determining at the power meter a phase of the voltage based on the received voltage and the injected signal.
18. The method of clause 17, comprising:
   measuring the voltage subsequent to receiving the injected signal; and
   calculating a signal indicitive of the phase of the voltage based on the measured transmission.
19. The method of clause 17, comprising transmitting the signal indicative of the phase of the voltage
20. The method of clause 17 comprising determining the source of the voltage based on the received injected signal.

## Claims

1. A system, comprising:
a power distribution station (12) adapted to generate an injected signal (58) at a specified time (60) and to transmit voltage and the injected signal (58); and
a phase detection device (22) adapted to receive the voltage and the injected signal (58) and to determine a phase (52) of the received voltage based on the relationship between the received voltage and the injected signal (58).

2. The system of claim 1, wherein the phase detection device (22) comprises a power meter.

3. The system of claim 1 or 2, wherein the phase detection (22) device comprises a hand-held metering device.

4. The system of any of the preceding claims, wherein the phase detection device (22) determines the phase (52) of the received voltage by determining a time relationship between the injected signal (58) and an oscillating wave of the received voltage.

5. The system of any of the preceding claims, wherein the phase detection device (22) determines the phase (52) of the received voltage by determining a direction of a slope of the received voltage during a measurement time period subsequent to receiving the injected signal (58).

6. The system of any of the preceding claims, wherein the power distribution station comprises a signal generator (42) adapted to generate the injected signal (58).

7. The system of claim 6, comprising a power line (14), wherein the power distribution station (12) comprises a transformer (48) adapted to transfer the injected signal (58) onto the power line (14) for transmission to the phase detection device (22).

8. The system of any of the preceding claims, wherein the phase detection device (22) comprises a transmitter (32) adapted to transmit a signal indicative of the phase of the received voltage to the power distribution station (12).

9. The system of claim 8, wherein the transmitter (32) comprises a wireless transmitter adapted to wirelessly transmit a signal indicative of the phase of the received voltage to the power distribution station (12).

10. A method, comprising:
receiving at a power meter (22) a voltage in one of three phases (52);
receiving at the power meter (22) an injected signal (58); and
determining at the power meter (22) a phase (52) of the voltage based on the received voltage and the injected signal (58).

11. The method of claim 10, comprising:
measuring the voltage subsequent to receiving the injected signal (58); and
calculating a signal indicitive of the phase of the voltage based on the measured transmission.

12. The method of claim 10 or claim 11, comprising transmitting the signal indicative of the phase of the voltage

13. The method of any of claims 10 to 12, comprising determining the source of the voltage based on the received injected signal (58).
